Europäisches Patentamt

European Patent Office

Office européen des brevets

(19)

(11) Publication number: **0 093 514**

**A1**

(12) # EUROPEAN PATENT APPLICATION

(21) Application number: 83301974.8

(22) Date of filing: 07.04.83

(51) Int. Cl.³: **H 01 L 31/06**
**H 01 L 31/18**

(30) Priority: 12.04.82 US 367815

(43) Date of publication of application:
09.11.83 Bulletin 83/45

(84) Designated Contracting States:
DE FR GB

(71) Applicant: CHEVRON RESEARCH COMPANY
525 Market Street
San Francisco California 94120(US)

(72) Inventor: Madan, Arun
21830 Cabrini Blvd Look Out Mountain
Golden Colorado 80401(US)

(74) Representative: Kosmin, Gerald Emmanuel et al,
HASELTINE, LAKE & CO. Hazlitt House 28 Southampton
Buildings Chancery Lane
London, WC2A 1AT(GB)

(54) Amorphous silicon solar cell incorporating an insulating layer to suppress back diffusion of holes into an N-type region and method of fabrication thereof.

(57) In an hydrogenated amorphous silicon solar cell which includes a body of hydrogenated amorphous silicon having layers of differing conductivity (14,16 and 20) with an interface between a photoactive intrinsic hydrogenated amorphous silicon layer (16) and an incident N-type layer (20) of hydrogenated amorphous silicon, the back diffusion of holes into the N-type layer is reduced by positioning between the photoactive layer (16) and the N-type layer (20) a thin layer (18) of insulator material, such as $Si_3N_4$ or $SiO_2$. The solar cell is advantageously fabricated in a glow discharge apparatus.

FIG.__1.

EP 0 093 514 A1

Amorphous silicon solar cell incorporating an insulating layer to suppress back diffusion of holes into an N-type region and method of fabrication thereof

This invention relates to thin film solar cells and in particular to thin film hydrogenated amorphous silicon solar cells and to a method of making the same.

Photovoltaic cells are capable of converting solar radiation into usable electrical energy. The energy conversion occurs as a result of what is well known in the solar cell field as the photovoltaic effect. Solar radiation impinging on a solar cell is absorbed by the semiconductor layer which generates holes and electrons. The electrons and holes are separated by a built-in electric field, for example, a rectifying junction such as an NIP junction in the solar cell. The electrons flow from the photoactive intrinsic layer (I layer) towards the N-type layer and the holes flow towards the P-type layer. The separation of the electrons and holes across the rectifying junction results in the generation of an electric current known as the photocurrent and an electric voltage known as the photovoltage.

Various types of solar cells are being actively researched to create devices which can effectively compete with conventionally generated forms of electricity. The research is focused on two main alternatives. One research area has focused on small area high efficiency single crystal silicon or III-V compound solar cells such as gallium arsenide. The III-V cells are used in conjunction with a concentrating lens. The other main research area has focused on inexpensive thin film solar devices such as $Cu_xS/CdS$ or hydrogenated amorphous silicon or hydrofluorinated amorphous silicon.

This invention focuses on thin film hydrogenated amorphous silicon solar cells. G.A. Swartz, J. Appl. Phys. 53(1), January 1982, pp 712-719, teaches that the major loss mechanism in a $N^+IP^+$ amorphous silicon solar cell is the back diffusion of holes into the thin $N^+$-type region. The first letter, $(N^+)$, indicates the region through which solar radiation first penetrates the solar cell. More generally, this loss mechanism applies to any solar cell wherein the light first enters the cell through a region which ohmically contacts the top electrical contact. Thus, it would be highly desirable to have an amorphous silicon solar cell which incorporates a means for minimizing or eliminating the major loss mechanism and a method of reducing or eliminating the back diffusion of holes into the thin $N^+$-type region of the solar cell.

In accordance with the present invention, there is provided an hydrogenated amorphous silicon solar cell which comprises a body of hydrogenated amorphous silicon having layers of different conductivity including an incident N-type or $N^+$-type layer of hydrogenated amorphous silicon and a photoactive intrinsic hydrogenated amorphous silicon layer, characterized in that the body of hydrogenated amorphous silicon incorporates an insulating layer between said incident N-type or $N^+$-type layer and said photoactive intrinsic silicon layer, said insulating layer having a thickness such as to reflect holes back into the photoactive intrinsic layer whilst permitting electrons to pass therethrough.

The invention also provides a method of inhibiting the transfer of holes from a layer of photoactive intrinsic hydrogenated amorphous silicon to an incident N-type layer of hydrogenated amorphous silicon in interfacial contact therewith, which comprises:

fabricating an insulating layer between said N-type layer of hydrogenated amorphous silicon and the photoactive intrinsic hydrogenated amorphous silicon layer, said insulating layer having an electron affinity which is substantially the same as that of the amorphous silicon and a thickness which maximizes the quantum efficiency of the amorphous silicon at the blue end of the AM1 excitation spectrum.

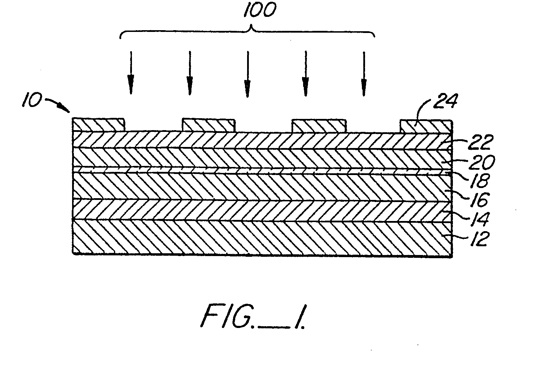

For a better understanding of the invention and to show how the same may be carried into effect, reference will now be made, by way of example, to the accompanying drawing which shows in Figure 1 a vertical cross-section of a preferred embodiment of a solar cell constructed in accordance with the invention.

Referring now to the drawing, FIG. 1 depicts an NIP solar cell designated as 10, hereinafter solar cell 10. Solar radiation 100, impinging on the solar cell 10, forms a reference point for the incident surface of each layer or region of the solar cell. The incident surface is defined as the major surface which is first incident to solar radiation. The opposed major surface and layer in which the solar radiation exits in passing to the next incident surface is defined to be the opposed major surface of the layer. The solar cell 10 includes an electrically conductive substrate 12 of, for example, stainless steel, molybdenum, or titanium. Alternatively, the substrate 12 may comprise glass coated with an electrically conductive material, for example gold or silver, or a transparent conductive oxide (TCO), for example tin oxide or indium tin oxide. If desired, a highly reflective layer of a metal, for example aluminium or chromium, may be incorporated on the substrate 12 to reflect light back into the semiconductor material.

The solar cell 10 incorporates a first layer 14 of P-type conductivity, preferably $p^+$-type conductivity graded to a P-type conductivity of amorphous silicon contacting the substrate 12. The $P^+$-type conductivity ensures an ohmic contact to the substrate. The layer 14 may be fabricated, for example, by glow discharge or sputtering. Glow discharging is the preferred method of fabrication. The layer 14 generally has a thickness of from 10 to 50 nanometers, preferably about 30 nanometers, with a bandgap energy of 1.2-1.4 eV and a doping concentration of from 25,000 to 35,000 volume parts per million (vol. ppm), preferably about 30,000 vol. ppm, of a suitable P-type dopant, for example boron, gallium or aluminium. Preferably, the dopant is boron and is incorporated into the amorphous silicon through the use of the doping gas $B_2H_6$. Optionally, a wide bandgap energy material, i.e. 1.8-2.0 eV, can be fabricated by incorporating methane, ammonia, nitrogen or nitrous oxide along with the silane and P-tye dopant.

Contacting the P-type layer 14 is a photoactive layer 16 of intrinsic amorphous silicon. The photoactive layer 16 generally has a thickness of from 400 to 1,000 nanometers, preferably about 500 nanometers, with a bandgap energy of at least 1.7 eV. The layer 16 is the layer of the solar cell 10 wherein solar radiation is absorbed and is converted into electrons and holes which are swept to the N-type and P-type layers, respectively.

Contacting the photoactive layer 16 is an insulating layer 18 of an insulator material, for example $SiO_2$, $Si_3N_4$, BN, $Ta_2O_5$ or $Nb_2O_5$. The insulating layer 18 is generally from 1 to 5 nanometers thick, preferably about 3 nanometers thick. Preferably, the insulating layer is formed from $Si_3N_4$ or $SiO_2$, because these insulator materials are easily fabricated in a glow discharge apparatus used to fabricate the amorphous silicon. The insulating layer 18 suppresses the back diffusion of holes which increases the short circuit current $(J_{sc})$ of the solar cell.

The insulating layer 18 is selected and/or adjusted so that the electron affinity of the insulator material is the same as that of the photoactive semiconductor material and there is no impediment to the electric current flow. However, this insulating layer presents a barrier to the back diffusion of holes because of the wider bandgap energy of the insulating layer in comparison to the bandgap energy of the semiconductor layer. This suppression of the back diffusion of holes increases the quantum efficiency of the solar cell in the blue region of the solar spectrum. The thickness of the insulating layer is adjusted to maximize the quantum efficiency at the blue end of the AM1 excitation spectrum. Beyond this thickness, the overall quantum efficiency of the solar cell is decreased because the solar cell operates in tunnel dominated regime rather than a semiconductor regime.

A layer 20 of N-type amorphous silicon contacts the insulating layer 18. The layer 20 incorporates a suitable N-type dopant, for example phosphorus or arsenic, in a concentration of generally from 5,000 to 15,000, preferably about 10,000 vol. ppm of an N-type dopant. The layer 20 generally has a thickness of 10-40 nanometers, preferably about 25 nanometers. The layer 20 preferably has a bandgap energy of about 1.8 eV and is graded from N-type to $N^+$-type at its incident surface. The $N^+$-type conductivity ensures an ohmic contact to the incident electrode layer 22. Preferably the dopant is phosphorus and is incorporated into the layer through the use of the doping gas $PH_3$.

Contacting the layer 20 is a transparent conducting electrode layer 22 formed from a transparent conductive metal or oxide. The layer 22 forms the incident electrode of the solar cell 10. The layer 22 generally has a thickness of 50 to 100 nanometers with a conductivity of less than 60 ohms/square preferably less than 30 ohms/square and most preferably less than 20 ohms/square. The actual thickness of layer 22 can be adjusted to serve as an integral antireflection coating. As the area of the device increases, a grid electrode 24 can be incorporated into the solar cell to withdraw the photogenerated current therefrom.

The solar cell can be fabricated by reactively sputtering silicon or by the chemical vapour deposition of silicon, or preferably by glow discharge of a silicon-hydrogen- or silicon-halogen-hydrogen-containing gas such as silane, dichlorosilane, difluorosilane, or silicon tetrachloride and hydrogen gas. The solar cell can be fabricated by procedures taught in United States Patent 4,064,521, or in accordance with the procedures outlined in United States Patent 4,226,898. Suitable glow discharge apparatus is commercially available, such as a Model 2306 of Plasma Systems, Inc., a subsidiary of Plasma-Therm, Inc., Woburn, MA, a Model PWS 450 Coyote, a product of Pacific Western Systems, Inc, Mountainview, CA, or a model PND-301-MQ(6), a product of LFE Corp., Waltham, MA.

For example, P-type or $P^+$-type hydrogenated amorphous silicon can be fabricated from $SiH_4+B_2H_6$, $SiH_4+H_2+B_2H_6$, $SiF_4+H_2+B_2H_6$, $SiCl_2H_2+H_2+B_2H_6$, or the halogenated silicon gases plus hydrogen and a P-type dopant. Wide bandgap P-type material can be fabricated from $SiH_4+CH_4+B_2H_6$, $SiH_4+N_2O+B_2H_6$, $SiH_4+NH_3+B_2H_6$, or the halogenated silicon gases and $CH_4$ or $NH_3$. N-type or $N^+$-type material can be fabricated from the same materials as the P-type material, however, $PH_3$, $AsH_3$ or other suitable N-type dopant is substituted for the P-type dopant. Suitable substrate temperatures are from 250 - 350°C with a power density of 0.2-2 $w/cm^2$, a flow rate of 5-50 SCCM and a deposition pressure of 0.1-2 torr.

More specifically, a conductive substrate such as stainless steel is placed in a glow discharge apparatus and the system is evacuated to a background pressure of

about $10^{-6}$ torr. Thereafter, the substrate is heated to a temperature of about $280^{\circ}$C. Silane ($SiH_4$) or dichlorosilane and hydrogen is introduced into the chamber along with about 3 volume percent $B_2H_6$. The flow rate of the silane containng $B_2H_6$ is about 20 SCCM. Thereafter, the electrodes of the glow discharge apparatus are energized and about a 30 nanometer layer of $P^+$-type to P-type hydrogenated amorphous silicon is grown on the substrate. Optionally, $CH_4$ or $N_2O$ gas can be included in the glow discharge atmosphere to widen the bandgap energy of the P-type material. The background pressure of the apparatus at this point and for subsequent depositions is about 0.5 torr.

After the growth of the $P^+$-type layer, the photoactive intrinsic region of the cell is fabricated by continuing the introduction of silane at a flow rate of about 20 SCCM with the $B_2H_6$ turned off until a layer about 500 nanometers thick of intrinsic hydrogenated amorphous silicon is grown on the $P^+$-type layer.

Thereafter, the insulating layer is grown on the photoactive intrinsic layer by, for example, continuing the flow of silane while introducing ammonia in a ratio of 70% silane/30% ammonia to grow a layer about 3 nanometers thick of $Si_3N_4$. An appropriate flow rate for the silane is about 15 SCCM and for the ammonia is about 5 SCCM. During the growth process the surface substrate temperature is about $280^{\circ}$C. Alternatively, the insulator material could be fabricated of silicon dioxide ($SiO_2$) by means of the introduction of silane and nitrous oxide ($N_2O$) in a ratio of 50/50.

The completion of the amorphous silicon part of the cell is completed by introducing silane with phosphine ($PH_3$). $PH_3$ is present generally in an amount from 0.5 to 2% of the atmosphere until about a 20 nanometer layer of N-type to $N^+$-type hydrogenated amorphous silicon is grown on the photoactive intrinsic layer. The substrate temperature is about 280°C during the growth of this layer.

Thereafter, a transparent conductive oxide layer and if necessary, grid contact is ohmically fabricated on the $N^+$-type layer by methods known in the art, such as evaporation for the TCO layer and photolithographic techniques for the grid contact.

If desired, a plurality of such solar cells may be stacked, with the cells being separated by a tunnel junction.

The incorporation in the solar cell of the insulating layer acts as a mirror to reflect the holes which would migrate into the incident N-type layer and combine with electrons and thereby reduce the efficiency of the device. Although the invention has been described with reference to an NIP amorphous silicon solar cell, the invention is equally applicable to improving the performance of amorphous silicon solar cells which incorporate a Schottky-barrier metal layer touching the intrinsic region wherein the insulating region would be placed between the photoactive intrinsic region and an incident N-type layer of the solar cell. In addition, the solar cell may include one or more cermet layers as taught in U.S. 4,162,505. The solar cell may also be fabricated as a solar battery type structure as disclosed in U.S. 4,316,049.

CLAIMS

1. An hydrogenated amorphous silicon solar cell which comprises a body of hydrogenated amorphous silicon having layers of differing conductivity including an incident N-type or $N^+$-type layer of hydrogenated amorphous silicon and a photoactive intrinsic hydrogenated amorphous silicon layer, characterized in that the body of hydrogenated amorphous silicon incorporates an insulating layer between said incident N-type or $N^+$-type layer and said photoactive intrinsic silicon layer, said insulating layer having a thickness such as to reflect holes back into the photoactive intrinsic layer whilst permitting electrons to pass therethrough.

2. A solar cell as claimed in Claim 1, wherein the insulating layer is from 1 to 5 nanometers thick.

3. A solar cell as claimed in Claim 1 or 2, wherein the insulating layer is formed from an insulator material selected from $Si_3N_4$, $SiO_2$, BN, $Ta_2O_5$ and $Nb_2O_5$.

4. A solar cell as claimed in Claim 3, wherein the insulator material is $Si_3N_4$.

5. A solar cell as claimed in Claim 3, wherein the insulator material is $SiO_2$.

6. A solar cell as claimed in any preceding claim, wherein the cell has the layered structure of N-type amorphous silicon/insulator material/photoactive intrinsic amorphous silicon/P-type amorphous silicon.

7. A solar cell as claimed in Claim 6, wherein the P-type amorphous silicon layer is from 20 to 50 nanometers in thickness, the photoactive intrinsic silicon layer is from 400 to 1,000 nanometers in thickness, and the N-type layer is from 10 to 40 nanometers in thickness.

8. A solar cell as claimed in Claim 6 or 7, wherein a plurality of the solar cells are stacked, with the cells being separated by a tunnel junction.

9. A method of inhibiting the transfer of holes from a layer of photoactive intrinsic hydrogenated amorphous silicon to an incident N-type layer of hydrogenated amorphous silicon in interfacial contact therewith, which comprises:

fabricating an insulating layer between said N-type layer of hydrogenated amorphous silicon and the photoactive intrinsic hydrogenated amorphous silicon layer, said insulating layer having an electron affinity which is substantially the same as that of the amorphous silicon and a thickness which maximizes the quantum efficiency of the amorphous silicon at the blue end of the AM1 excitation spectrum.

10. A method according to Claim 9, wherein the insulating layer is from 1 to 5 nanometers in thickness.

11. A method according to Claim 9 or 10, wherein the insulating layer is formed from an insulator material selected from $Si_3N_4$, $SiO_2$, BN, $Ta_2O_5$ and $Nb_2O_5$.

12. A method according to Claim 11, wherein the insulator material is $Si_3N_4$ which is fabricated by a glow discharge in an atmosphere comprising 70% $SiH_4$ and 30% $NH_3$ with a substrate temperature of about 280°C.

13. A method according to Claim 11, wherein the insulator material is $SiO_2$ which is fabricated by a glow discharge in a 50/50 mixture $SiH_4$ and $N_2O$ with a substrate temperature of about 280°C.

1/1

100

10

24

22
20
18
16
14
12

*FIG.__ 1.*

## European Patent Office

# EUROPEAN SEARCH REPORT

Application number

EP 83 30 1974

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | APPLIED PHYSICS LETTERS, vol. 37, no. 9, November 1980, New York A. MADAN et al. "Metal-insulator-semiconductor solar cells using amorphous Si:F:H alloys", pages 826-828 * Whole document * | 1-3,6 9-11 | H 01 L 31/06 H 01 L 31/18 |
| | --- | | |
| Y | JOURNAL OF APPLIED PHYSICS, vol. 52, no. 12, December 1981, New York K. SEN et al. "A new structure for a semiconductor-insulator-semiconductor solar cell", pages 7309-7312 * Whole document * | 1,6,9 | |
| | --- | | |
| Y | DE-A-2 826 752 (RCA) * Page 4, paragraph 3 - page 5, paragraph 3; page 6, paragraph 6 - page 10, paragraph 2; figure 1 * | 1-3,6 9-11 | TECHNICAL FIELDS SEARCHED (Int. Cl. ³) |
| A | * Page 9, paragraph 2; page 16, paragraph 3 - page 17, paragraph 1; figure 1 * | 4,5,12 | H 01 L 31/00 |
| | --- | | |
| A | US-A-4 217 148 (D.E. CARLSON) * Column 1, line 38 - column 4, line 21; figures 1, 2 * | 1,7,9 12 | |
| | ---          -/- | | |

The present search report has been drawn up for all claims

| Place of search BERLIN | Date of completion of the search 01-07-1983 | Examiner ROUSSEL A T |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | US-A-4 272 641 (J.J. HANAK) <br> * Column 1, line 17 - column 3, line 48; figures 1, 2 * <br><br> ----- | 7,8 | |
| | | | **TECHNICAL FIELDS SEARCHED (Int. Cl. ³)** |

The present search report has been drawn up for all claims

| Place of search <br> BERLIN | Date of completion of the search <br> 01-07-1983 | Examiner <br> ROUSSEL A T |
|---|---|---|